# EUROPEAN PATENT APPLICATION

(11) **EP 3 287 274 A1**
(43) Date of publication of application: **28.02.2018**
(21) Application number: 16783205.4
(22) Date of filing: 20.04.2016
(51) Int. Cl.: B32B 9/00, B32B 27/00, G02F 1/1333

(54) **GAS BARRIER FILM, ELECTRONIC DEVICE MEMBER, AND ELECTRONIC DEVICE**

(30) Priority: 22.04.2015 JP 2015087371
(71) Applicant: LINTEC Corporation, Tokyo 173-0001 (JP)
(72) Inventor: SUZUKI Yuta, Tokyo 173-0001 (JP); IWAYA Wataru, Tokyo 173-0001 (JP)
(74) Representative: Beckmann, Claus
(86) International application number: PCT/JP2016/062544
(87) International publication number: WO 2016/171184

(57) **Abstract**

The present invention is: a gas barrier film comprising a base film and a gas barrier layer formed by modifying a layer containing a polysilazane-based compound and formed on the base film, wherein the gas barrier film has a water vapor transmission rate of 0.100 g/(m²·day) or less, and an amount of hydrogen gas released from the gas barrier layer under an argon gas atmosphere at 60°C and a relative humidity of 90% is 5.5 µg or less per cm² of the gas barrier film; an electronic device member comprising the gas barrier film; and an electronic device comprising this electronic device member. The present invention provides a gas barrier film having a gas barrier layer which has excellent gas barrier properties and has less outgases generation, an electronic device member comprising the gas barrier film, and an electronic device comprising the electronic device member.

## Description

### Technical Field

The present invention relates to a gas barrier film having a gas barrier layer which has excellent gas barrier properties and has less outgases generation, an electronic device member comprising this gas barrier film, and an electronic device comprising this electronic device member.

### Background Art

In recent years, in a display such as a liquid crystal display or an electroluminescence (EL) display, the so-called gas barrier film, which is obtained by laminating a gas barrier layer on a transparent plastic film, has been used instead of a glass plate as a substrate having an electrode in order to realize thinning, weight reduction, flexibility, and the like.

As the method for forming a gas barrier layer, a method is known which involves modifying a layer containing a polysilazane-based compound by implanting ions into the layer containing the polysilazane-based compound, or exposing the surface of the layer to plasma.

For example, Patent Literature 1 describes a formed article having a layer formed by implanting ions into a layer containing a polysilazane-based compound. In this literature, it is also stated that this layer formed by implanting ions can function as a gas barrier layer.

### Citation List

### Patent Literature

Patent Literature 1: Japanese Patent Laid-Open No. 2012-117150 (US2012064321A1)

### Summary of Invention

### Technical Problem

As described in Patent Literature 1, a gas barrier film having excellent gas barrier properties can be obtained by modifying a layer containing a polysilazane-based compound formed on a base.

However, in a gas barrier film obtained by such a method, slight amounts of hydrogen gas and the like may be generated from the gas barrier layer when a slight amount of water vapor enters the gas barrier layer. When such a gas barrier film is used as a member of an electronic device, generated gases may cause the failure and appearance deterioration of the electronic device.

The present invention has been made in view of the above circumstances, and it is an object of the present invention to provide a gas barrier film having a gas barrier layer which has excellent gas barrier properties and has less outgases generation, an electronic device member comprising this gas barrier film, and an electronic device comprising this electronic device member.

### Solution to Problem

In order to solve the above problem, the present inventors have diligently studied a gas barrier film having a gas barrier layer formed by modifying a layer containing a polysilazane-based compound. As a result, the present inventors have found that a gas barrier layer which has less outgases generation even if a slight amount of water vapor enters can be formed by applying an coating liquid comprising a polysilazane-based compound, then bringing the polysilazane-based compound in the obtained coating and moisture into sufficient contact with each other, and then modifying the layer comprising the above polysilazane-based compound; and thus have completed the present invention.

Thus, according to the present invention, the gas barrier films of (1) to (3), the electronic device member of (4), and the electronic device of (5) described below are provided.
(1) A gas barrier film comprising a base film and a gas barrier layer formed by modifying a layer containing a polysilazane-based compound and formed on the base film, the gas barrier film having a water vapor transmission rate of 0.100 g/(m²·day) or less, and an amount of hydrogen gas released from the gas barrier layer under an argon gas atmosphere at 60°C and a relative humidity of 90% being 5.5 µg or less per cm² of the gas barrier film.
(2) The gas barrier film according to (1), wherein a thickness of the gas barrier layer is 10 nm to 1 µm.
(3) The gas barrier film according to (1), wherein the gas barrier layer is a layer modified by subjecting a layer comprising a polysilazane-based compound to ion implantation treatment, plasma treatment, ultraviolet irradiation treatment, or heat treatment.
(4) An electronic device member comprising the gas barrier film according to any of the above (1) to (3).
(5) An electronic device comprising the electronic device member according to the above (4).

### Advantageous Effects of Invention

According to the present invention, a gas barrier film having a gas barrier layer which has excellent gas barrier properties and has less outgases generation, an electronic device member comprising this gas barrier film, and an electronic device comprising this electronic device member are provided.

### Description of Embodiments

The present invention will be itemized as 1) a gas barrier film and 2) an electronic device member and an electronic device and described in detail below.

### 1) Gas Barrier Film

The gas barrier film of the present invention comprises a base film and a gas barrier layer formed by modifying a layer containing a polysilazane-based compound (hereinafter sometimes referred to as a "polysilazane layer") and formed on the base film, and has a water vapor transmission rate of 0.100 g/(m²·day) or less, and the amount of hydrogen gas released from the above gas barrier layer under an argon gas atmosphere at 60°C and a relative humidity of 90% is 5.5 µg or less per cm² of the gas barrier film.

### (1) Base Film

The base film constituting the gas barrier film of the present invention is not particularly limited as long as it has sufficient strength as the base of the gas barrier film.

As the base film, a resin film is usually used.

Examples of the resin component of the resin film include polyimides, polyamides, polyamideimides, polyphenylene ethers, polyetherketones, polyetheretherketones, polyolefins, polyesters, polycarbonates, polysulfones, polyethersulfones, polyphenylene sulfides, acrylic resins, cycloolefin-based polymers, and aromatic polymers.

Among these, because of excellent transparency, and versatility, polyesters, polyamides, or cycloolefin-based polymers are preferred, and polyesters or cycloolefin-based polymers are more preferred.

Examples of the polyesters include polyethylene terephthalate, polybutylene terephthalate, polyethylene naphthalate, and polyarylates. Polyethylene terephthalate is preferred.

Examples of the polyamides include wholly aromatic polyamides, nylon 6, nylon 66, and nylon copolymers.

Examples of the cycloolefin-based polymers include norbornene-based polymers, monocyclic olefin-based polymers, cyclic conjugated diene-based polymers, vinyl alicyclic hydrocarbon polymers, and hydrogenated product threof. Specific examples thereof include APEL (ethylene-cycloolefin copolymer manufactured by Mitsui Chemicals, Inc.), ARTON (norbornene-based polymer manufactured by JSR Corporation), and ZEONOR (norbornene-based polymer manufactured by ZEON Corporation).

The resin film may contain various additives as long as they do not impair the effect of the present invention. Examples of the additives include UV absorbers, antistatic agents, stabilizers, antioxidants, plasticizers, lubricants, and coloring pigments. The content of these additives should be appropriately determined according to the purpose.

The resin film can be obtained by preparing a resin composition comprising a resin component, and various additives as desired, and forming the resin composition into a film shape. The forming method is not particularly limited, and known methods such as casting, melt extrusion, or the like can be used.

The thickness of the base film is not particularly limited and can be determined according to the purpose of the gas barrier film. The thickness of the base film is usually 0.5 to 500 µm, preferably 1 to 100 µm.

The light transmittance of the base film at 380 to 780 nm is preferably 80% or more, more preferably 85% or more.

### (2) Gas Barrier Layer

The gas barrier layer constituting the gas barrier film of the present invention is formed by modifying a polysilazane layer.

In the present invention, the gas barrier layer refers to a layer derived from a polysilazane layer and having gas barrier properties (the property of suppressing the passage of gases such as oxygen and water vapor). For example, when only the surface portion of the polysilazane layer is modified, the gas barrier layer of the present invention comprises both a modified region and an unmodified region.

The polysilazane-based compound contained in the polysilazane layer is a compound having a repeating unit containing a -Si-N- bond (silazane bond) in the molecule. Specifically, a compound having a repeating unit represented by formula (1): 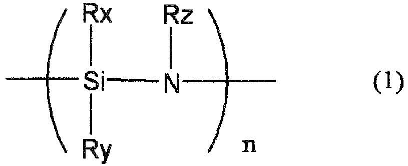 is preferred. The number average molecular weight of the polysilazane-based compound used is not particularly limited but is preferably 100 to 50,000.

In the above formula (1), n represents any natural number. Rx, Ry, and Rz each independently represent a hydrogen atom or a non-hydrolyzable group such as an unsubstituted or substituted alkyl group, an unsubstituted or substituted cycloalkyl group, an unsubstituted or substituted alkenyl group, an unsubstituted or substituted aryl group, or an alkylsilyl group.

Examples of the alkyl group of the above unsubstituted or substituted alkyl group include alkyl groups having 1 to 10 carbon atoms such as a methyl group, an ethyl group, an n-propyl group, an isopropyl group, an n-butyl group, an isobutyl group, a sec-butyl group, a t-butyl group, an n-pentyl group, an isopentyl group, a neopentyl group, an n-hexyl group, an n-heptyl group, and an n-octyl group.

Examples of the cycloalkyl group of the unsubstituted or substituted cycloalkyl group include cycloalkyl groups having 3 to 10 carbon atoms such as a cyclobutyl group, a cyclopentyl group, a cyclohexyl group, and a cycloheptyl group.

Examples of the alkenyl group of the unsubstituted or substituted alkenyl group include alkenyl groups having 2 to 10 carbon atoms such as a vinyl group, a 1-propenyl group, a 2-propenyl group, a 1-butenyl group, a 2-butenyl group, and a 3-butenyl group.

Examples of the substituents of the above alkyl group, cycloalkyl group, and alkenyl group include halogen atoms such as a fluorine atom, a chlorine atom, a bromine atom, and an iodine atom; a hydroxyl group; a thiol group; an epoxy group; a glycidoxy group; a (meth)acryloyloxy group; and unsubstituted or substituted aryl groups such as a phenyl group, a 4-methylphenyl group, and a 4-chlorophenyl group.

Examples of the aryl group of the unsubstituted or substituted aryl group for Rx, Ry, and Rz include aryl groups having 6 to 10 carbon atoms such as a phenyl group, a 1-naphthyl group, and a 2-naphthyl group.

Examples of the substituent of the above aryl group include halogen atoms such as a fluorine atom, a chlorine atom, a bromine atom, and an iodine atom; alkyl groups having 1 to 6 carbon atoms such as a methyl group and an ethyl group; alkoxy groups having 1 to 6 carbon atoms such as a methoxy group and an ethoxy group; a nitro group; a cyano group; a hydroxyl group; a thiol group; an epoxy group; a glycidoxy group; a (meth)acryloyloxy group; and unsubstituted or substituted aryl groups such as a phenyl group, a 4-methylphenyl group, and a 4-chlorophenyl group.

Examples of the alkylsilyl group include a trimethylsilyl group, a triethylsilyl group, a triisopropylsilyl group, a tri-t-butylsilyl group, a methyldiethylsilyl group, a dimethylsilyl group, a diethylsilyl group, a methylsilyl group, and an ethylsilyl group.

Among these, as Rx, Ry, and Rz, a hydrogen atom, alkyl groups having 1 to 6 carbon atoms, or a phenyl group is preferred, and a hydrogen atom is particularly preferred.

The polysilazane-based compound having the repeating unit represented by the above formula (1) may be either an inorganic polysilazane in which Rx, Ry, and Rz are all hydrogen atoms or an organic polysilazane in which at least one of Rx, Ry, and Rz is not a hydrogen atom.

In the present invention, as the polysilazane-based compound, a polysilazane modified product can also be used. Examples of the polysilazane modified product include those described in Japanese Patent Laid-Open No. 62-195024, Japanese Patent Laid-Open No. 2-84437, Japanese Patent Laid-Open No. 63-81122, Japanese Patent Laid-Open No. 1-138108, and the like, Japanese Patent Laid-Open No. 2-175726, Japanese Patent Laid-Open No. 5-238827, Japanese Patent Laid-Open No. 5-238827, Japanese Patent Laid-Open No. 6-122852, Japanese Patent Laid-Open No. 6-306329, Japanese Patent Laid-Open No. 6-299118, Japanese Patent Laid-Open No. 9-31333, Japanese Patent Laid-Open No. 5-345826, Japanese Patent Laid-Open No. 4-63833, and the like.

Among these, as the polysilazane-based compound, perhydropolysilazane in which Rx, Ry, and Rz are all hydrogen atoms is preferred in view of easy availability and being able to form an ion-implanted layer having excellent gas barrier properties.

As the polysilazane-based compound, a commercial product commercially available as a glass coating material or the like can also be used as it is.

One polysilazane-based compound can be used alone, or two or more polysilazane-based compounds can be used in combination.

The polysilazane layer may contain other components in addition to the above-described polysilazane-based compound as long as they do not inhibit achieving the object of the present invention. Examples of the other components include curing agents, anti-aging agents, light stabilizers, and flame retardants.

The content of the polysilazane-based compound in the polysilazane layer is preferably 50% by mass or more, more preferably 70% by mass or more, because a gas barrier layer having better gas barrier properties is obtained.

The thickness of the polysilazane layer is not particularly limited but is usually 10 nm to 1 µm, preferably 10 to 500 nm.

In the present invention, even if the polysilazane layer is of the nano-order, a gas barrier laminate having sufficient gas barrier properties can be obtained.

The method for forming the polysilazane layer is not particularly limited. For example, the polysilazane layer can be formed by preparing a polysilazane layer-forming solution containing at least one polysilazane-based compound, other components as desired, a solvent, and the like, then applying this polysilazane layer-forming solution by a known method, and drying the obtained coating.

Examples of the solvent used in the polysilazane layer-forming solution include aromatic hydrocarbon-based solvents such as benzene and toluene; ester-based solvents such as ethyl acetate and butyl acetate; ketone-based solvents such as acetone, methyl ethyl ketone, and methyl isobutyl ketone; aliphatic hydrocarbon-based solvents such as n-pentane, n-hexane, and n-heptane; and alicyclic hydrocarbon-based solvents such as cyclopentane and cyclohexane.

One of these solvents can be used alone, or two or more of these solvents can be used in combination.

Examples of the method for applying the polysilazane layer-forming solution include bar coating, spin coating, dipping, roll coating, gravure coating, knife coating, air knife coating, roll knife coating, die coating, screen printing, spray coating, and gravure offset.

When the gas barrier film of the present invention is manufactured, it is preferred that the polysilazane-based compound in the coating formed by applying the polysilazane layer-forming solution be brought into sufficient contact with moisture. By bringing the polysilazane-based compound in the coating into sufficient contact with moisture, a gas barrier layer which has less outgases generatio even if a slight amount of water vapor enters can be efficiently formed.

The contact between the polysilazane-based compound in the coating and moisture can be made, for example, by allowing the laminate having the coating containing the polysilazane-based compound to stand under the conditions of a predetermined humidity and temperature for a predetermined time. The humidity, temperature, and time at this time can be appropriately set according to the purpose.

The humidity when the laminate having the above coating is allowed to stand may usually be a relative humidity of 0% to 100%. Even if the relative humidity is 0%, a slight amount of moisture is contained in other layers such as the base, and therefore this slight amount of moisture can be used. However, in this case, in order to efficiently bring the polysilazane-based compound and moisture into contact with each other, the laminate having the above coating is preferably allowed to stand at high temperature.

The temperature when the laminate having the above coating is allowed to stand is usually 5 to 150°C, preferably 10 to 130°C. Generally, when the relative humidity is low (for example, 30% or less), the polysilazane-based compound and moisture can be brought into sufficient contact with each other by allowing the laminate to stand under a higher temperature condition (for example, 100°C or more).

The time during which the laminate having the above coating is allowed to stand is usually 10 minutes to 1 week, preferably 30 minutes to 48 hours. The time should be appropriately determined according to the humidity condition and temperature condition adopted. Generally, when the time during which the laminate having the above coating is allowed to stand is short (for example, 15 minutes or less), the polysilazane-based compound and moisture can be brought into sufficient contact with each other by allowing the laminate to stand under a higher temperature condition (for example, 130°C or more).

The conditions under which the polysilazane-based compound in the coating and moisture are brought into contact with each other are preferably adopted optimally according to the thickness of the coating. The reason for this is that as the coating thickens, the contact between the polysilazane-based compound and moisture tends to become insufficient, and that the amounts of outgases generated from the formed gas barrier layer also tend to increase.

Generally, when the coating is thick (200 nm to 1 µm), it is preferred that the humidity, the temperature, and the time during which the laminate is allowed to stand be 50% or more, 100°C or more, and 24 hours or more, respectively.

On the other hand, when the thickness is small (less than 200 nm), a humidity of less than 50%, a temperature of less than 25°C, and a laminate standing time of about 1 hour are sufficient.

After the polysilazane-based compound and moisture are brought into contact with each other, the coating is dried as needed, and then the modification treatment of the polysilazane layer is performed.

Examples of the modification treatment of the polysilazane layer include ion implantation treatment, plasma treatment, ultraviolet irradiation treatment, and heat treatment.

The ion implantation treatment is a method in which ions are implanted into the polysilazane layer to modify the polysilazane layer as described later.

The plasma treatment is a method in which the polysilazane layer is exposed to plasma to modify the polysilazane layer. For example, plasma treatment can be performed according to a method described in Japanese Patent Laid-Open No. 2012-106421.

The ultraviolet irradiation treatment is a method in which the polysilazane layer is irradiated with ultraviolet rays to modify the polysilazane layer. For example, modification treatment with ultraviolet rays can be performed according to a method described in Japanese Patent Laid-Open No. 2013-226757.

Among these, ion implantation treatment is preferred because the polysilazane layer can be efficiently modified to its inside without roughening the surface of the polysilazane layer to thereby form a gas barrier layer having better gas barrier properties.

Examples of the ions implanted into the polysilazane layer include ions of rare gases such as argon, helium, neon, krypton, and xenon; ions of fluorocarbons, hydrogen, nitrogen, oxygen, carbon dioxide, chlorine, fluorine, sulfur, and the like; ions of alkane-based gases such as methane and ethane; ions of alkene-based gases such as ethylene and propylene; ions of alkadiene-based gases such as pentadiene and butadiene; ions of alkyne-based gases such as acetylene; ions of aromatic hydrocarbon-based gases such as benzene and toluene; ions of cycloalkane-based gases such as cyclopropane; ions of cycloalkene-based gases such as cyclopentene; ions of metals; and ions of organosilicon compounds.

One of these ions can be used alone, or two or more of these ions can be used in combination.

Among these, ions of rare gases such as argon, helium, neon, krypton, and xenon are preferred because these ions can be more simply implanted, and enable formation of a gas barrier layer having better gas barrier properties.

The amount of ions implanted can be appropriately determined according to the purpose of use of the gas barrier film (required gas barrier properties, transparency, and the like), and the like.

Examples of the method of implanting ions include a method in which ions accelerated by an electric field (ion beam) are radiated, and a method in which ions in plasma are implanted. Especially, the latter method, i.e., implanting plasma ions is preferred because the target gas barrier layer can be simply formed.

The plasma ion implantation can be performed, for example, by generating plasma under an atmosphere comprising a plasma-producing gas such as a rare gas, and applying negative high voltage pulses to the polysilazane layer to implant ions (cations) in the plasma into the surface portion of the polysilazane layer.

The thickness of the region into which ions are implanted by ion implantation can be controlled by implantation conditions such as the type of ions, the applied voltage, and the treatment time. The thickness can be determined according to the thickness of the polysilazane layer, the purpose of use of the gas barrier film, and the like and is usually 10 to 400 nm.

### (3) Gas Barrier Film

The gas barrier film of the present invention comprises a base film and a gas barrier layer formed by modifying a layer containing a polysilazane-based compound and formed on the base film.

The gas barrier film of the present invention may have a layer other than the base film and the gas barrier layer.

Examples of the layer other than the base film and the gas barrier layer include a primer layer, a conductor layer, an impact-absorbing layer, a pressure-sensitive adhesive layer, a hard coat layer, and a process sheet. The process sheet has the role of protecting the gas barrier film when storing and transporting the gas barrier film, and the like and is peeled when the gas barrier film is used.

Examples of the layer configuration of the gas barrier film of the present invention include, but are not limited to, the following:
(i) base film/gas barrier layer
(ii) hard coat layer/base film/gas barrier layer
(iii) base film/primer layer/gas barrier layer
(iv) hard coat layer/base film/primer layer/gas barrier layer

The thickness of the gas barrier film of the present invention is not particularly limited but is preferably 1 to 1000 µm, more preferably 10 to 500 µm, and further preferably 40 to 100 µm.

The water vapor transmission rate of the gas barrier film of the present invention at a temperature of 40°C and a relative humidity of 90% is 0.100 g/(m²·day) or less, preferably 0.050 g/(m²·day) or less, and more preferably 0.030 g/(m²·day) or less. There is no particular lower limit value, and the water vapor transmission rate is preferably lower but is usually 0.001 g/(m²·day) or more.

The water vapor transmission rate can be measured by a method described in Examples.

In the gas barrier film of the present invention, the amount of hydrogen gas released from the gas barrier layer under an argon gas atmosphere at 60°C and a relative humidity of 90% is 5.5 µg or less, preferably 5.0 µg or less, and more preferably 4.5 µg or less per cm² of the gas barrier film. There is no particular lower limit value, and the amount of hydrogen gas released is preferably smaller but is usually 0.1 µg or more.

The amount of hydrogen gas released can be measured by a method described in Examples.

Generally, a polysilazane-based compound reacts with moisture to produce hydrogen gas and ammonia gas. Therefore, when a gas barrier film is used as a sealing material or the like of an electronic device, a slight amount of moisture entering the gas barrier layer of the gas barrier film reacts with the polysilazane-based compound. Thus, these gases are generated, and the failure and appearance deterioration of the electronic device may be caused.

In the gas barrier layer constituting the gas barrier film of the present invention, the above reaction of the polysilazane-based compound is less likely to occur, and therefore in the gas barrier film of the present invention, the amounts of outgases released from the gas barrier layer when water vapor enters the gas barrier layer are small.

In this manner, the gas barrier film of the present invention has a gas barrier layer which has excellent gas barrier properties and has less outgases generation, and therefore is preferably used as an electronic device member.

### 2) Electronic Device Member and Electronic Device

The electronic device member of the present invention comprises the gas barrier film of the present invention. Therefore, the electronic device member of the present invention has excellent gas barrier properties, and the deterioration of an element due to gases such as water vapor can thus be prevented. In addition, in the electronic device member of the present invention, the amounts of outgases generated are small, and the possibility that the failure and appearance deterioration of an electronic device are caused is low. Therefore the electronic device member of the present invention is preferred as a member of display such as a liquid crystal display, an EL display, or the like.

The electronic device of the present invention comprises the electronic device member of the present invention. Specific examples include liquid crystal displays, organic EL displays, inorganic EL displays, electronic paper, and solar batteries.

The electronic device of the present invention comprises an electronic device member comprising the gas barrier film of the present invention. Therefore the electronic device of the present invention has excellent gas barrier properties, and the failure and appearance deterioration of the electronic device due to the generation of outgases are less likely to occur.

### Examples

The present invention will be described in more detail below by giving Examples. However, the present invention is not limited to the following Examples in any way.

Parts and % in examples are by mass unless otherwise noted.

### [Water Vapor transmission rate]

The water vapor transmission rate of a gas barrier film was measured using "AQUATRAN" manufactured by MOCON, Inc. The measurement was performed under an atmosphere at 40°C and a relative humidity of 90%.

### [Amount of Hydrogen Gas]

A gas barrier film was placed in a quartz chamber, and argon gas having a temperature of 60°C and having its relative humidity controlled at 90% was flowed therethrough. The gas passing through the quartz chamber was analyzed by an atmospheric pressure ionization-mass spectrometer (API-MS), and the amount of hydrogen gas contained therein was determined. The amount of hydrogen gas is an accumulated amount from the time of the start of the flowing of argon gas to the time when the detection peak of hydrogen becomes equal to that of the background.

### [Appearance of Device]

A device having the same structure as that of the organic EL element disclosed in Example 16 of Japanese Patent Laid-Open No. 2007-197517 except that a gas barrier film was used as the substrate was fabricated.

The device was allowed to stand in an environment at 60°C and a relative humidity of 90% for 24 hours, and then the appearance was observed.

### [Example 1]

A coating agent comprising perhydropolysilazane as a main component ("AZNN110-20" manufactured by Merck Performance Materials, Ltd.) was applied onto a polyethylene terephthalate film (hereinafter referred to as a "PET film") having a thickness of 50 µm (COSMOSHINE A-4100 manufactured by Toyobo Co., Ltd.) to form a coating, and the obtained PET film with the coating was heated at 120°C for 2 minutes to form a polysilazane layer having a thickness of 25 nm on the PET film.

Then, the above polysilazane layer was subjected to plasma ion implantation under the following conditions using a plasma ion implantation apparatus, to modify the surface of the polysilazane layer to obtain a gas barrier film. For this gas barrier film, various measurements were performed. The measurement results are shown in Table 1.

### [Plasma Ion Implantation Treatment Conditions]

Plasma-producing gas: argon
Gas flow rate: 100 sccm
Duty cycle: 0.5%
Repetition frequency: 1000 Hz
Applied voltage: -10 kV
RF output: 1000 W
RF power supply: (frequency) 13.56 MHz, (applied power) 1000 W
Chamber internal pressure: 0.2 Pa
Pulse width: 5 µsec
Treatment time (ion implantation time): 5 minutes
Conveyance speed: 0.2 m/min

### [Example 2]

A gas barrier film was obtained in the same manner as in Example 1 except that the thickness of the polysilazane layer was changed to 50 nm. Various measurements were performed. The measurement results are shown in Table 1.

### [Example 3]

A gas barrier film was obtained in the same manner as in Example 1 except that the thickness of the polysilazane layer was changed to 100 nm. Various measurements were performed. The measurement results are shown in Table 1.

### [Example 4]

A gas barrier film was obtained in the same manner as in Example 1 except that the thickness of the polysilazane layer was changed to 200 nm. Various measurements were performed. The measurement results are shown in Table 1.

### [Example 5]

A gas barrier film was obtained in the same manner as in Example 1 except that the thickness of the polysilazane layer was changed to 300 nm. Various measurements were performed. The measurement results are shown in Table 1.

### [Example 6]

A gas barrier film was obtained in the same manner as in Example 1 except that the thickness of the polysilazane layer was changed to 400 nm, and that after the coating agent was applied, the resultant was allowed to stand in an environment at 23°C and a relative humidity of 50% for 24 hours. Various measurements were performed. The measurement results are shown in Table 1.

### [Example 7]

A gas barrier film was obtained in the same manner as in Example 1 except that the thickness of the polysilazane layer was changed to 400 nm, and that after the coating agent was applied, the resultant was allowed to stand in an environment at 80°C and a relative humidity of 50% for 3 hours. Various measurements were performed. The measurement results are shown in Table 1.

### [Example 8]

A gas barrier film was obtained in the same manner as in Example 1 except that the thickness of the polysilazane layer was changed to 400 nm, and that after the coating agent was applied, the resultant was allowed to stand in an environment at 120°C and a relative humidity of 0% for 1 hour. Various measurements were performed. The measurement results are shown in Table 1.

### [Example 9]

A gas barrier film was obtained in the same manner as in Example 1 except that instead of subjecting the polysilazane layer to plasma ion implantation treatment, the polysilazane layer was subjected to plasma treatment under the following conditions using a roll electrode type plasma discharge treatment apparatus. Various measurements were performed. The measurement results are shown in Table 1.

### [Plasma Treatment Conditions]

A plurality of rod-shaped electrodes opposed to roll electrodes were installed parallel to the film conveyance direction. Gases and power were introduced into the electrode portions, and the surface of the polysilazane layer was irradiated with plasma for 20 seconds.
Discharge gas: Ar gas
Reaction gas: 7% of oxygen gas based on all gases
Power of high frequency side power supply: 8 W/cm² at 13.56 MHz

### [Example 10]

A gas barrier film was obtained in the same manner as in Example 1 except that instead of subjecting the polysilazane layer to plasma ion implantation treatment, the polysilazane layer was subjected to excimer treatment under the following conditions using an excimer irradiation apparatus (MECL-M-1-200 manufactured by M.D.COM Inc., wavelength: 172 nm, lamp-enclosed gas: Xe). Various measurements were performed. The measurement results are shown in Table 1.

### [Excimer Treatment Conditions]

The film fixed on a movable stage was subjected to modification treatment under the following conditions:
Excimer light intensity: 130 mW/cm² (172 nm)
Distance between film and light source: 1 mm
Stage heating temperature: 70°C
Oxygen concentration in irradiation apparatus: 0.5%
Excimer irradiation time: 3 seconds

### [Comparative Example 1]

A gas barrier film was obtained in the same manner as in Example 1 except that the thickness of the polysilazane layer was changed to 400 nm. Various measurements were performed. The measurement results are shown in Table 1.

### [Comparative Example 2]

A gas barrier film was obtained in the same manner as in Example 1 except that the thickness of the polysilazane layer was changed to 500 nm. Various measurements were performed. The measurement results are shown in Table 1.

**Table 1**

| | Water vapor transmission rate | Amount of hydrogen gas | Appearance of device |
|---|---|---|---|
| | g/(m²·day) | µg/cm² | |
| Example 1 | 0.040 | 0.4 | There is no problem |
| Example 2 | 0.030 | 0.8 | There is no problem |
| Example 3 | 0.020 | 1.5 | There is no problem |
| Example 4 | 0.007 | 2.9 | There is no problem |
| Example 5 | 0.006 | 4.4 | There is no problem |
| Example 6 | 0.005 | 3.5 | There is no problem |
| Example 7 | 0.005 | 1.2 | There is no problem |
| Example 8 | 0.005 | 0 | There is no problem |
| Example 9 | 0.040 | 0.6 | There is no problem |
| Example 10 | 0.040 | 0.6 | There is no problem |
| Comparative Example 1 | 0.005 | 5.9 | There are blisters |
| Comparative Example 2 | 0.004 | 7.3 | There are blisters |

From Table 1, the following are found.

The gas barrier films obtained in Examples 1 to 10 have sufficient gas barrier properties, and even if their gas barrier layers come into contact with water vapor, the amount of hydrogen gas generated is small. In the devices comprising these gas barrier films, no problem in appearance occurred.

On the other hand, the amount of hydrogen gas generated when the gas barrier layers of the gas barrier films obtained in Comparative Examples 1 and 2 came into contact with water vapor was large, and in the devices comprising these gas barrier films, blisters occurred.

## Claims

1. A gas barrier film comprising a base film and a gas barrier layer formed by modifying a layer containing a polysilazane-based compound and formed on the base film,
the gas barrier film having a water vapor transmission rate of 0.100 g/(m²·day) or less, and
an amount of hydrogen gas released from the gas barrier layer under an argon gas atmosphere at 60°C and a relative humidity of 90% being 5.5 µg or less per cm² of the gas barrier film.

2. The gas barrier film according to claim 1, wherein a thickness of the gas barrier layer is 10 nm to 1 µm.

3. The gas barrier film according to claim 1, wherein the gas barrier layer is a layer modified by subjecting a layer comprising a polysilazane-based compound to ion implantation treatment, plasma treatment, ultraviolet irradiation treatment, or heat treatment.

4. An electronic device member comprising a gas barrier film according to any of claims 1 to 3.

5. An electronic device comprising an electronic device member according to claim 4.
